# EUROPÄISCHE PATENTSCHRIFT

(11) **EP 3 345 225 B1**
(45) Veröffentlichungstag und Bekanntmachung des Hinweises auf die Patenterteilung: **27.11.2019**
(21) Anmeldenummer: 16756681.9
(22) Anmeldetag: 22.08.2016
(51) Int. Cl.: H01L 33/48, H01L 33/64, H01L 33/62

(54) **OPTOELEKTRONISCHES HALBLEITERBAUELEMENT UND VERFAHREN ZU DESSEN HERSTELLUNG**
OPTOELECTRONIC SEMICONDUCTOR COMPONENT AND METHOD FOR PRODUCING SAME
COMPOSANT SEMI-CONDUCTEUR OPTOÉLECTRONIQUE ET SON PROCÉDÉ DE FABRICATION

(30) Priorität: 01.09.2015 DE 102015114587
(43) Veröffentlichungstag der Anmeldung: 11.07.2018
(73) Patentinhaber: OSRAM Opto Semiconductors GmbH, 93055 Regensburg (DE)
(72) Erfinder: PERZLMAIER, Korbinian, 93055 Regensburg (DE); KASPRZAK-ZABLOCKA, Anna, 93093 Donaustauf (DE); HÖPPEL, Lutz, 93087 Alteglofsheim (DE); LEIRER, Christian, 93053 Regensburg (DE)
(74) Vertreter: Epping - Hermann - Fischer
(86) Internationale Anmeldenummer: PCT/EP2016/069813
(87) Internationale Veröffentlichungsnummer: WO 2017/036841

(56) Entgegenhaltungen:
- WO-A1-2016/078837
- DE-A1-102010 025 320
- US-A1- 2008 157 333
- US-A1- 2013 292 735
- US-A1- 2015 181 711

## Beschreibung

Die Anmeldung betrifft ein optoelektronisches Halbleiterbauelement, das einen Halbleiterkörper und einen Träger aus einem Kunststoffmaterial aufweist, und ein Verfahren zu dessen Herstellung.

Diese Patentanmeldung beansprucht die Priorität der deutschen Patentanmeldung 10 2015 114 587.1. Das optoelektronische Halbleiterbauelement kann insbesondere einen Halbleiterkörper und einen mit einem Gießverfahren hergestellten Kunststoffträger aufweisen, der zur elektrischen Kontaktierung des Halbleiterkörpers mit Durchkontaktierungen versehen ist.

Aus den Druckschriften US 2013/0292735 A1, DE 102010025320 A1, US 2015/0181711 A1 und US 2008/0157333 A1 sind jeweils optoelektronische Halbleiterbauelemente bekannt, die einen Träger mit Durchkontaktierungen aufweisen.

Eine zu lösende Aufgabe besteht darin, ein verbessertes optoelektronisches Halbleiterbauelement anzugeben, das sich durch verbesserte mechanische und/oder elektrooptische Eigenschaften auszeichnet und vergleichsweise einfach herstellbar ist.

Diese Aufgaben werden durch ein optoelektronisches Halbleiterbauelement und ein Verfahren zu dessen Herstellung gemäß den unabhängigen Patentansprüchen gelöst. Vorteilhafte Ausgestaltungen und Weiterbildungen der Erfindung sind Gegenstand der abhängigen Ansprüche.

Das optoelektronische Halbleiterbauelement weist einen Halbleiterkörper auf, der eine Halbleiterschichtenfolge mit einem p-Typ Halbleiterbereich, einem n-Typ Halbleiterbereich und einer zwischen dem p-Typ Halbleiterbereich und dem n-Typ Halbleiterbereich angeordneten aktiven Schicht aufweist. Die aktive Schicht kann insbesondere eine strahlungsemittierende aktive Schicht sein. Der p-Typ Halbleiterbereich, der n-Typ Halbleiterbereich und die aktive Schicht können jeweils eine oder mehrere Halbleiterschichten umfassen. Der p-Typ Halbleiterbereich enthält eine oder mehrere p-dotierte Halbleiterschichten und der n-dotierte Halbleiterbereich eine oder mehrere n-dotierte Halbleiterschichten. Es ist auch möglich, dass der p-Typ Halbleiterbereich und/oder der n-Typ Halbleiterbereich eine oder mehrere undotierte Halbleiterschichten enthalten.

Die aktive Schicht kann zum Beispiel als pn-Übergang, als Doppelheterostruktur, als Einfach-Quantentopfstruktur oder Mehrfach-Quantentopfstruktur ausgebildet sein. Die Bezeichnung Quantentopfstruktur umfasst dabei jegliche Struktur, bei der Ladungsträger durch Einschluss (Confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Weiterhin weist das optoelektronische Halbleiterbauelement einen Träger auf, der einen Kunststoff aufweist. Der Träger kann insbesondere mittels eines Gießverfahrens hergestellt sein. Mit anderen Worten ist der Träger ein sogenannter Moldkörper. Unter dem Begriff Gießverfahren fallen hierbei alle Herstellungsverfahren, bei denen eine Formmasse in eine vorgegebene Form eingebracht wird und insbesondere nachfolgend gehärtet wird. Insbesondere umfasst der Begriff Gießverfahren Gießen (Casting, Potting), Spritzgießen (Injection Molding), Spritzpressen (Transfer Molding) und Formpressen (Compression Molding). Bevorzugt wird der Träger durch Formpressen oder durch ein folienassistiertes Gießverfahren (Film Assisted Transfer Molding) ausgebildet.

Der Kunststoff des Trägers weist vorzugsweise ein Gießharz, wie z. B. ein Epoxidharz, oder ein Silikon auf. Der Kunststoff kann einen oder mehrere Zusatzstoffe als Beimischung enthalten. Beispielsweise kann der Träger SiO2-Partikel zur Einstellung des thermischen Ausdehnungskoeffizienten aufweisen. Der Träger kann zum Beispiel eine Dicke zwischen 80 µm und 500 um, bevorzugt zwischen 100 um und 200 um, typischerweise etwa 100 µm aufweisen.

Der Träger weist eine erste Durchkontaktierung und eine zweite Durchkontaktierung auf, die jeweils von einer dem Halbleiterkörper zugewandten ersten Hauptfläche des Trägers zu einer vom Halbleiterkörper abgewandten zweiten Hauptfläche des Trägers geführt sind.

Dadurch, dass die Durchkontaktierungen von der ersten Hauptfläche des Trägers zur gegenüberliegenden zweiten Hauptfläche des Trägers geführt sind, kann das optoelektronische Bauelement vorteilhaft an der zweiten Hauptfläche des Trägers mit elektrischen Anschlüssen versehen werden. Insbesondere kann das optoelektronische Bauelement an der zweiten Hauptfläche des Trägers mit Leiterbahnen einer Leiterplatte verbunden werden, indem beispielsweise die erste Durchkontaktierung mit einer Lotschicht mit einer ersten Leiterbahn einer Leiterplatte und die zweite Durchkontaktierung mit einer zweiten Lotschicht mit einer zweiten Leiterbahn der Leiterplatte verbunden wird. Das optoelektronische Bauelement ist also vorteilhaft oberflächenmontierbar.

Weiterhin weist das optoelektronische Halbleiterbauelement eine p-Kontaktschicht und eine n-Kontaktschicht auf, die zumindest bereichsweise zwischen dem Träger und dem Halbleiterkörper angeordnet sind, wobei die p-Kontaktschicht elektrisch leitend mit der ersten Durchkontaktierung und dem p-Typ Halbleiterbereich verbunden ist, und die n-Kontaktschicht elektrisch leitend mit der zweiten Durchkontaktierung und dem n-Typ Halbleiterbereich verbunden ist. Die p-Kontaktschicht und die n-Kontaktschicht sind durch mindestens eine elektrisch isolierende Schicht voneinander isoliert. Vorteilhaft werden bei dem optoelektronischen Halbleiterchip sowohl der p-Typ Halbleiterbereich als auch der n-Typ Halbleiterbereich von der Seite des Trägers her kontaktiert. Dies hat den Vorteil, dass eine dem Träger gegenüberliegende Strahlungsaustrittsfläche des Halbleiterkörpers frei von Anschlussschichten sein kann. Die Strahlungsausbeute wird auf diese Weise vorteilhaft erhöht.

Weiterhin ist es vorteilhaft, wenn die n-Kontaktschicht und/oder die p-Kontaktschicht für die von der aktiven Schicht emittierte Strahlung reflektierend sind, um in Richtung des Trägers emittierte Strahlung zur Strahlungsaustrittsfläche hin zu reflektieren. Die n-Kontaktschicht und/oder die p-Kontaktschicht können insbesondere eine reflektierende Metallschicht umfassen und enthalten vorzugsweise Silber, Gold oder Aluminium. Es ist möglich, dass die n-Kontaktschicht und/oder die p-Kontaktschicht mehrere Teilschichten umfassen, insbesondere eine Metallschicht und eine Schicht aus einem transparenten leitfähigen Oxid wie beispielsweise ITO oder dotiertes ZnO, wobei der Dotierstoff zum Beispiel A1 oder Ga sein kann.

Das optoelektronische Halbleiterbauelement weist eine metallische Verstärkungsschicht auf, welche zumindest bereichsweise zwischen der Halbleiterschichtenfolge und dem Träger angeordnet ist. Die metallische Verstärkungsschicht ist insbesondere zumindest bereichsweise zwischen der n-Kontaktschicht und dem Träger angeordnet. Die metallische Verstärkungsschicht enthält ein Metall oder eine Metalllegierung und ist mindestens 5 um, besonders bevorzugt mindestens 10 um, dick. Durch die vergleichsweise dicke metallische Verstärkungsschicht zwischen dem Träger und der Halbleiterschichtenfolge wird bei dem optoelektronischen Halbleiterbauelement eine verbesserte mechanische Stabilität erzielt. Die metallische Verstärkungsschicht kann zumindest bereichsweise unmittelbar an den Träger angrenzen und/oder durch eine dielektrische Schicht von dem Träger getrennt sein.

Weiterhin umfasst das optoelektronische Halbleiterbauelement eine p-Kontaktdurchführung, die zwischen der ersten Durchkontaktierung und der p-Kontaktschicht angeordnet ist. Die p-Kontaktdurchführung weist vorteilhaft wie die metallische Verstärkungsschicht ein Metall oder eine Metalllegierung auf.

Gemäß zumindest einer Ausführungsform ist die mindestens eine p-Kontaktdurchführung wie die metallische Verstärkungsschicht mindestens 5 µm, bevorzugt mindestens 10 um, dick. Insbesondere kann die p-Kontaktdurchführung durch galvanische Abscheidung hergestellt werden. Die mindestens eine p-Kontaktdurchführung ist vorzugsweise in lateraler Richtung zumindest bereichsweise von der Verstärkungsschicht umgeben. Die p-Kontaktdurchführung und die Verstärkungsschicht liegen mit anderen Worten zumindest bereichsweise in einer Ebene. Die p-Kontaktdurchführung grenzt hierbei nicht direkt an die Verstärkungsschicht an, sondern ist vorteilhaft durch eine elektrisch isolierende Schicht von der Verstärkungsschicht isoliert, wobei die elektrisch isolierende Schicht vorzugsweise nicht mehr als 5 µm dick ist. Vorzugsweise ist mit Ausnahme des Bereichs der elektrisch isolierenden Schicht die gesamte zwischen dem Träger und der Halbleiterschichtenfolge angeordnete Fläche des optoelektronischen Halbleiterbauelements entweder von der metallischen Verstärkungsschicht oder der p-Kontaktdurchführung bedeckt. Die beiden vergleichsweise dicken Schichten der metallischen Verstärkungsschicht und der p-Kontaktdurchführung bilden so gemeinsam eine mechanische Verstärkung des optoelektronischen Halbleiterbauelements an der dem Träger zugewandten Fläche aus.

An einer dem Träger zugewandten Grenzfläche weist die metallische Verstärkungsschicht bevorzugt eine rms-Rauheit von mindestens 50 nm auf. Dadurch, dass die metallische Verstärkungsschicht an einer dem Träger zugewandten Grenzfläche eine rms-Rauheit von mindestens 50 nm, bevorzugt von mindestens 100 nm, besonders bevorzugt von mindestens 200 nm, aufweist, wird die Haftung des Trägers und/oder der dielektrischen Schicht an der metallischen Verstärkungsschicht vorteilhaft verbessert und so die mechanische Stabilität des optoelektronischen Halbleiterbauelements weiter verbessert.

Die metallische Verstärkungsschicht enthält vorzugsweise Nickel oder Kupfer oder besteht daraus. Es hat sich herausgestellt, dass beispielsweise eine Nickelschicht oder Kupferschicht insbesondere durch galvanische Abscheidung auf einfache Weise mit einer vergleichsweise großen Rauheit hergestellt werden kann, wobei die rms-Rauheit mindestens 50 nm oder sogar mindestens 200 nm beträgt. Ein separater Prozessschritt zur Aufrauung der metallischen Verstärkungsschicht, beispielsweise ein Ätzprozess, kann, aber muss nicht notwendigerweise durchgeführt werden, wenn bei der galvanischen Abscheidung bereits eine rms-Rauheit von mindestens 50 nm erzielt wird. Dies kann beispielsweise dadurch erreicht werden, dass dem elektrolytischen Bad zur galvanischen Abscheidung der metallischen Verstärkungsschicht keine Zusatzstoffe hinzugefügt werden, welche eine Verringerung der Oberflächenrauheit der abgeschiedenen Schicht bewirken. Insbesondere bei der galvanischen Abscheidung einer Nickelschicht oder Kupferschicht kann im elektrolytischen Bad eine Schicht mit einer rms-Rauheit von mehr als 50 nm erzielt werden, die nicht durch einen separaten Prozessschritt aufgeraut werden muss.

Gemäß zumindest einer Ausgestaltung ist zwischen dem Träger und der metallischen Verstärkungsschicht eine dielektrische Schicht angeordnet. Die dielektrische Schicht ist vorzugsweise eine anorganische Schicht, besonders bevorzugt eine Siliziumoxidschicht. Die dielektrische Schicht ist vorzugsweise konform zu der metallischen Verstärkungsschicht ausgebildet. Mit anderen Worten weist die Oberfläche der dielektrischen Schicht vorzugsweise im Wesentlichen die gleiche Rauheit auf wie die metallische Verstärkungsschicht. Die rms-Rauheit der dielektrischen Schicht kann insbesondere mindestens 50 nm, bevorzugt mindestens 100 nm, besonders bevorzugt mindestens 200 nm, betragen. Die dielektrische Schicht kann direkt an den Träger angrenzen und aufgrund ihrer Rauheit die Haftung des Trägers verbessern. Durch die Rauheit der metallischen Verstärkungsschicht, die sich in die dielektrische Schicht überträgt, verbessert sich auch die Haftung der dielektrischen Schicht auf der metallischen Verstärkungsschicht.

Die dielektrische Schicht ist vorzugsweise zumindest teilweise zwischen der metallischen Verstärkungsschicht und der p-Kontaktdurchführung angeordnet. Die dielektrische Schicht wird vorzugsweise nach dem Aufbringen der metallischen Verstärkungsschicht aufgebracht und bedeckt auch die Seitenflanken der metallischen Verstärkungsschicht. Die p-Kontaktdurchführung wird vorzugsweise nach dem Aufbringen der dielektrischen Schicht in einer Öffnung der metallischen Verstärkungsschicht hergestellt, wobei die der Öffnung zugewandten Seitenflanken der Verstärkungsschicht mit der dielektrischen Schicht versehen sind.

Gemäß zumindest einer vorteilhaften Ausgestaltung ist die Halbleiterschichtenfolge in lateraler Richtung zumindest bereichsweise von dem Träger umgeben. Die Halbleiterschichtenfolge wird auf diese Weise seitlich von dem Träger geschützt. Bevorzugt grenzt die Halbleiterschichtenfolge an keiner Stelle direkt an den Träger an, sondern ist durch mindestens eine metallische und/oder dielektrische Schicht von dem Träger getrennt. Das Kunststoffmaterial des Trägers wird auf diese Weise vorteilhaft vor der emittierten Strahlung der aktiven Schicht geschützt. Insbesondere kann die Verstärkungsschicht in lateraler Richtung gesehen zumindest bereichsweise zwischen der Halbleiterschichtenfolge und dem Träger angeordnet sein. Die metallische Verstärkungsschicht bewirkt auf diese Weise auch in seitlicher Richtung eine verbesserte mechanische Stabilität und einen Schutz der Halbleiterschichtenfolge. Das optoelektronische Halbleiterbauelement weist schräge Seitenflanken auf, die zumindest bereichsweise von Außenseiten des Trägers gebildet sind. Die Seitenflanken verlaufen derart schräg, dass sich ein Querschnitt des optoelektronischen Bauelements vom Träger zu einer Strahlungsaustrittsfläche hin verjüngt. Mit anderen Worten ist das optoelektronische Bauelement an der Seite des Trägers breiter als an einer dem Träger gegenüberliegenden Strahlungsaustrittsfläche. Dies hat den Vorteil, dass der optoelektronische Halbleiterchip beim Greifen von der Seite im Wesentlichen nur an der Seite des Trägers berührt wird, während gegebenenfalls an der Strahlungsaustrittsfläche angeordnete Schichten nicht berührt werden.

Dies ist insbesondere bei einer bevorzugten Ausgestaltung von Vorteil, bei der an einer Strahlungsaustrittsfläche des optoelektronischen Halbleiterchips eine Konverterschicht angeordnet ist. Die Konverterschicht kann einen oder mehrere Lumineszenzkonversionsstoffe enthalten, die beispielsweise in ein Matrixmaterial wie zum Beispiel ein Silikon eingebettet sind. Die Konverterschicht wird beim Greifen des Chips von der Seite aufgrund der schrägen Seitenflanken vorteilhaft nicht berührt, so dass insbesondere nicht die Gefahr besteht, dass die Konverterschicht beschädigt und/oder das Greifwerkzeug mit Material der Konverterschicht verunreinigt wird.

Bei einer bevorzugten Ausgestaltung steht die Konverterschicht in lateraler Richtung um eine Länge L von mindestens 5 um, bevorzugt zwischen mindestens 5 µm und höchstens 50 um, über die Halbleiterschichtenfolge über. Auf diese Weise wird vorteilhaft vermieden, dass am Rand des optoelektronischen Halbleiterchips Strahlung emittiert wird, die nicht die Konverterschicht durchlaufen hat und zum Beispiel einen unerwünschten blauen Farbeindruck aufweist. Es ist weiterhin auch möglich, dass die Konverterschicht seitlich über die vorzugsweise schrägen Seitenflanken übersteht.

Gemäß einer weiteren vorteilhaften Ausgestaltung weist die Konverterschicht eine Fase auf. Mit anderen Worten ist die Kante der Konverterschicht an der Oberfläche nicht rechtwinklig ausgebildet, sondern schräg, beispielsweise mit einem 45°-Winkel zur Oberfläche der Konverterschicht, oder die Kante ist abgerundet. Auf diese Weise wird verhindert, dass in Richtung der oberseitigen Kante der Konverterschicht emittiertes Licht einen besonders langen Weg durch die Konverterschicht zurücklegt und deshalb einen überhöhten Anteil an konvertiertem Licht aufweist.

Gemäß einer weiteren vorteilhaften Ausgestaltung sind Seitenflächen der Konverterschicht mit einer lichtabsorbierenden oder reflektierenden Schicht bedeckt. Auf diese Weise wird verhindert, dass am Rand der Konverterschicht Licht emittiert wird, das im Vergleich zu in senkrechter Richtung emittiertem Licht einen sehr großen Weg in der Konverterschicht zurückgelegt hat und deshalb einen anderen Farbeindruck, beispielsweise einen gelblichen Farbeindruck, aufweist.

Im Fall einer lichtabsorbierenden Schicht weist diese bevorzugt eine variierende Dicke auf, die zu einer Oberfläche der Konverterschicht hin zunimmt. Auf diese Weise wird das am oberen Rand der Konverterschicht emittierte Licht, das einen besonders langen Weg durch die Konverterschicht zurückgelegt hat und deshalb einen besonders hohen Anteil an konvertiertem Licht aufweist, stärker geschwächt, um beispielsweise einen gelblichen Farbdruck zu vermindern.

Bei einer weiteren möglichen Ausgestaltung nimmt eine Konzentration von Konverterpartikeln in der Konverterschicht in Richtung zur Außenseite der Konverterschicht hin ab. Auf diese Weise kann erreicht werden, dass das in Richtung der Außenseite emittierte Licht zwar einen längeren Weg durch die Konverterschicht zurücklegt, aber aufgrund der geringeren Konzentration der Konverterpartikel im Außenbereich in etwa gleich stark konvertiert wird wie senkrecht emittiertes Licht.

Bei einer weiteren möglichen Ausgestaltung weist die Konverterschicht im Zentrum eine größere Dicke als an den Außenseiten auf. Dies kann beispielsweise dadurch realisiert werden, dass bei einem Verfahrensschritt, bei dem die Halbleiterschichtenfolge durch Ätzen aufgeraut wird, im Zentrum der Halbleiterschichtenfolge mehr Material abgetragen wird als im Außenbereich, so dass im Zentrum eine Vertiefung entsteht. Wenn die Konverterschicht dann beispielsweise in flüssiger oder gelartiger Form aufgebracht wird, entsteht eine im Zentrum dickere Konverterschicht. Auf diese Weise wird der Weg der Strahlung durch das Konvertermaterial für senkrecht emittiertes Licht vergrößert, um den für schräg emittiertes Licht vergrößerten Weg durch das Konvertermaterial zumindest teilweise zu kompensieren und so die Farbe-über-Winkel-Homogenität der Strahlung zu verbessern.

Bei einer bevorzugten Ausführungsform weist die n-Kontaktschicht mindestens einen n-Durchgangskontakt auf, der durch einen Durchbruch in dem p-Typ Halbleiterbereich und der aktiven Schicht in den n-Typ Halbleiterbereich geführt ist. Im Bereich des Durchbruchs ist der mindestens eine n-Durchgangskontakt durch eine elektrisch isolierende Schicht von der aktiven Schicht und dem p-Typ Halbleiterbereich getrennt. Die mindestens eine p-Kontaktdurchführung ist vorzugsweise von dem mindestens einen n-Durchgangskontakt in lateraler Richtung beabstandet. Anders ausgedrückt liegen der n-Durchgangskontakt oder die mehreren n-Durchgangskontakte in vertikaler Richtung nicht über der p-Kontaktdurchführung oder den mehreren p-Kontaktdurchführungen. In Draufsicht gibt es also vorteilhaft an keiner Stelle einen Überlapp zwischen einer p-Kontaktdurchführung und einem n-Durchgangskontakt.

Bei einer weiteren vorteilhaften Ausgestaltung ist die p-Kontaktschicht bereichsweise von einer Verkapselungsschicht bedeckt. Die Verkapselungsschicht ist vorzugsweise eine anorganische dielektrische Schicht, insbesondere eine Oxid- oder Nitridschicht wie beispielsweise eine Siliziumoxidschicht, eine Aluminiumoxidschicht oder eine Siliziumnitridschicht.

Bei einem Verfahren zur Herstellung des optoelektronischen Halbleiterchips werden die Verstärkungsschicht und/oder die p-Kontaktdurchführung vorteilhaft durch galvanische Abscheidung hergestellt. Durch die galvanische Abscheidung lässt sich insbesondere die Verstärkungsschicht mit einer vergleichsweise großen rms-Rauheit von mindestens 50 nm herstellen. Insbesondere ist dies bei der galvanischen Abscheidung einer Nickelschicht oder Kupferschicht der Fall.

Weiterhin ist es bei dem Herstellungsverfahren vorteilhaft, wenn die dielektrische Schicht, welche zumindest bereichsweise auf der metallischen Verstärkungsschicht angeordnet ist, eine Siliziumoxidschicht ist, die durch chemische Gasphasenabscheidung aus Tetraethylorthosilikat (TEOS) hergestellt wird. Es hat sich herausgestellt, dass es mit diesem Verfahren gelingt, eine zu der Verstärkungsschicht konforme Schicht abzuscheiden, welche im Wesentlichen die gleiche Rauheit wie die Verstärkungsschicht aufweist. Bevorzugt beträgt die rms-Rauheit der dielektrischen Schicht wie die rms-Rauheit der metallischen Verstärkungsschicht mindestens 50 nm, besonders bevorzugt mindestens 200 nm.

Weitere vorteilhafte Ausgestaltungen des Verfahrens ergeben sich aus der vorherigen Beschreibung des optoelektronischen Halbleiterbauelements und umgekehrt.

Die Erfindung wird im Folgenden anhand von Ausführungsbeispielen im Zusammenhang mit den Figuren 1 bis 4 näher erläutert.

Es zeigen:
- Figur 1: eine schematische Darstellung eines Querschnitts durch ein optoelektronisches Bauelement gemäß einem erstem Ausführungsbeispiel,
- Figuren 2A bis 2M: eine schematische Darstellung eines Ausführungsbeispiels des Verfahrens zur Herstellung des optoelektronischen Bauelements anhand von Zwischenschritten,
- Figur 3: eine schematische Darstellung eines Querschnitts durch ein optoelektronisches Bauelement gemäß einem zweiten Ausführungsbeispiel, und
- Figur 4: eine schematische Darstellung eines Querschnitts durch ein optoelektronisches Bauelement gemäß einem dritten Ausführungsbeispiel.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

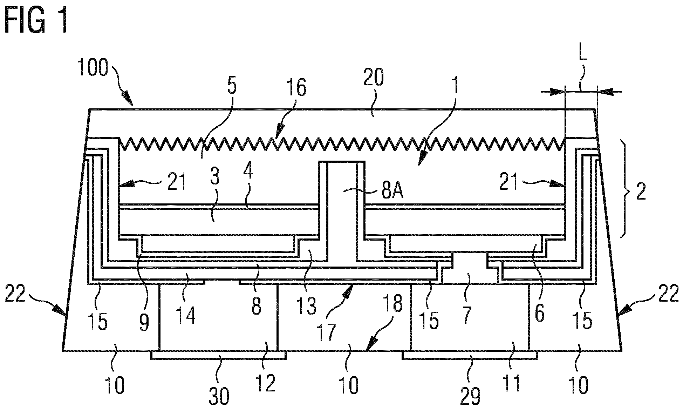

Bei dem in Figur 1 dargestellten ersten Ausführungsbeispiel eines optoelektronischen Halbleiterbauelements 100 handelt es sich um eine LED. Die LED weist einen Halbleiterkörper 1 auf, der eine Halbleiterschichtenfolge 2 mit einer zur Strahlungsemission geeigneten aktiven Schicht 4 aufweist. Die aktive Schicht 4 kann beispielsweise einen pn-Übergang oder eine Einfach- oder Mehrfachquantentopfstruktur zur Strahlungserzeugung aufweisen. Die aktive Schicht 4 ist zwischen einem p-Typ-Halbleiterbereich 3 und einem n-Typ Halbleiterbereich 5 angeordnet.

Die Halbleiterschichtenfolge 2 basiert vorzugsweise auf einem III-V-Verbindungshalbleitermaterial, insbesondere auf einem Arsenid-, Nitrid- oder Phosphidverbindungshalbleitermaterial. Beispielsweise kann die Halbleiterschichtenfolge 2 InₓAl_{y}Ga_{1-x-y}N, InₓAl_{y}Ga_{1-x-y}P oder InₓAl_{y}Ga_{1-x-y}As, jeweils mit 0 ≤ x ≤ 1, 0 ≤ y ≤ 1 und x + y ≤ 1, enthalten. Dabei muss das III-V-Verbindungshalbleitermaterial nicht zwingend eine mathematisch exakte Zusammensetzung nach einer der obigen Formeln aufweisen. Vielmehr kann es einen oder mehrere Dotierstoffe sowie zusätzliche Bestandteile aufweisen, die die physikalischen Eigenschaften des Materials im Wesentlichen nicht ändern. Der Einfachheit halber beinhalten obige Formeln jedoch nur die wesentlichen Bestandteile des Kristallgitters, auch wenn diese teilweise durch geringe Mengen weiterer Stoffe ersetzt sein können.

Bei der LED gemäß dem Ausführungsbeispiel handelt es sich um eine sogenannte Dünnfilm-LED, von der ein zum Aufwachsen der Halbleiterschichtenfolge 2 verwendetes Aufwachssubstrat nachträglich von der Halbleiterschichtenfolge 2 abgelöst wurde. Das ursprüngliche Aufwachssubstrat, beispielsweise ein Saphir-, Silizium- oder GaAs-Substrat, wurde von der Seite des Halbleiterkörpers 1 abgelöst, an der sich nun die Strahlungsaustrittsfläche 16 befindet. Der Halbleiterkörper 1 kann an seiner Strahlungsaustrittsfläche 16 aufgeraut oder mit einer Strukturierung versehen sein, um die Strahlungsauskopplung aus dem Halbleiterkörper 1 zu verbessern. Die Strukturierung oder Aufrauung des Halbleiterkörpers 1 an der Strahlungsaustrittsfläche 16 kann insbesondere mit einem Ätzprozess erfolgen.

An einer der Strahlungsaustrittsfläche 16 gegenüberliegenden Oberfläche ist der Halbleiterkörper 1 mit einem Träger 10 verbunden. Der Träger 10 ist aus einem Kunststoff gebildet. Insbesondere kann der Träger 10 mittels Formpressens, Spritzpressens oder eines Gießverfahrens hergestellt sein. Das Kunststoffmaterial des Trägers 10 kann zum Beispiel ein Epoxidharz oder ein Silikon aufweisen.

Der Träger 10 weist eine dem Halbleiterkörper 1 zugewandte erste Hauptfläche 17 und eine vom Halbleiterkörper abgewandte zweite Hauptfläche 18 auf. Der Träger 10 weist eine erste Durchkontaktierung 11 und eine zweite Durchkontaktierung 12 auf, die jeweils von der ersten Hauptfläche 17 zur zweiten Hauptfläche 18 des Trägers 10 geführt sind. Die Durchkontaktierungen 11, 12 weisen vorteilhaft ein Metall oder eine Metalllegierung auf und können insbesondere galvanisch hergestellt sein. Die Durchkontaktierungen 11, 12 können zum Beispiel Cu, Ni oder ein Lot enthalten. Die beiden Durchkontaktierungen 11, 12 dienen zur elektrischen Kontaktierung des Halbleiterkörpers 1. Beispielsweise ist die erste Durchkontaktierung 11 mit dem p-Typ Halbleiterbereich 3 der Halbleiterschichtenfolge 2 und die zweite Durchkontaktierung 12 mit dem n-Typ Halbleiterbereich 5 elektrisch leitend verbunden.

An der Rückseite der Durchkontaktierungen 11, 12 können Rückseitenkontakte 29, 30 aufgebracht sein. Die Rückseitenkontakte können zum Beispiel ein Metall oder eine Metalllegierung, insbesondere ein Lot aufweisen. Die Rückseitenkontakte 29, 30 können zum Beispiel Au, Pd, Ag, Sn, Cu, Ni, Ti, Al, W und/oder Pt enthalten. Beispielsweise sind die Rückseitenkontakte 29, 30 eine CuSn-, NiSn-, CuNiSn-, TiAu-, TiPtAu-, NiAu-, TiAuSn-, TiPtAuSn-, NiAuSn- oder NiPdAu-Schicht. Auch können die Rückseitenkontakte 29, 30 eine SnAgCu-Schicht (SAC-Lotschicht), AuSn-, CuAgNi-Schicht oder eine reine Ag-, Cu- oder Au-Schicht sein.

Bei dem in Figur 1 dargestellten Ausführungsbeispiel stehen die Rückseitenkontakte über die Durchkontaktierungen 11, 12 über. Alternativ ist es aber auch möglich, dass die Rückseitenkontakte 29, 30 deckungsgleich mit den Durchkontaktierungen 11, 12 sind oder die Durchkontaktierungen 11, 12 nicht vollständig bedecken.

Eine elektrisch leitende Verbindung zwischen der ersten Durchkontaktierung 11 und dem p-Typ Halbleiterbereich 3 erfolgt insbesondere mittels einer p-Kontaktschicht 6, die beispielsweise an den p-Typ Halbleiterbereich angrenzt, und einer p-Kontaktdurchführung 7, die zwischen dem Halbleiterkörper 1 und dem Träger 10 angeordnet ist. Die p-Kontaktdurchführung 7 verbindet die erste Durchkontaktierung 11 mit der p-Kontaktschicht 6. Es ist auch möglich, dass die p-Kontaktdurchführung 7 ein Bestandteil der ersten Durchkontaktierung 11 ist. Beispielsweise können die p-Kontaktdurchführung 7 und die erste Durchkontaktierung 11 gleichzeitig, z.B. durch galvanische Abscheidung eines Metalls oder einer Metalllegierung, hergestellt werden.

Die zweite Durchkontaktierung 12 ist mittels einer n-Kontaktschicht 8, 8A mit dem n-Typ Halbleiterbereich 5 elektrisch leitend verbunden. Dies kann beispielsweise derart erfolgen, dass ein Teil der n-Kontaktschicht 8 durch mindestens einen Durchbruch durch die Halbleiterschichtenfolge 2 bis in den n-Typ Halbleiterbereich 5 geführt ist und auf diese Weise mindestens einen Durchgangskontakt 8A ausbildet. Die n-Kontaktschicht 8, 8A ist durch mindestens eine elektrisch isolierende Schicht 13 von dem p-Typ Halbleiterbereich 3, der aktiven Schicht 4, der p-Kontaktschicht 6 und der ersten Durchkontaktierung 11 elektrisch isoliert. Die mindestens eine elektrisch isolierende Schicht 13 kann zum Beispiel ein Siliziumoxid oder Aluminiumoxid aufweisen.

Die Kontaktierung des optoelektronischen Bauelements mittels der durch die aktive Zone 4 hindurch geführten n-Kontaktschicht 8, 8A hat den Vorteil, dass sowohl die Kontaktierung des n-Typ Halbleiterbereichs 5 als auch des p-Typ Halbleiterbereichs 3 von der dem Träger 10 zugewandten Seite des Halbleiterkörpers 1 aus erfolgt. Die Strahlungsaustrittsfläche 16 des optoelektronischen Bauelements ist daher vorteilhaft frei von elektrischen Kontaktelementen wie beispielsweise Bondpads, Kontaktmetallisierungen oder Anschlussdrähten. Auf diese Weise wird eine Absorption von Strahlung durch Kontaktelemente an der Strahlungsaustrittsfläche 16 verhindert.

An der dem Halbleiterkörper 1 gegenüberliegenden zweiten Hauptfläche 18 des Trägers 10 können die Durchkontaktierungen 11, 12 vorteilhaft von außen angeschlossen werden. Insbesondere können die elektrisch leitenden Durchkontaktierungen 11, 12 an der zweiten Hauptfläche 18 des Trägers 10 beispielsweise mit den Leiterbahnen einer Leiterplatte verbunden werden. Das optoelektronische Halbleiterbauelement ist also vorteilhaft oberflächenmontierbar.

Zwischen der n-Kontaktschicht 8 und dem Träger 10 ist vorteilhaft eine metallische Verstärkungsschicht 14 angeordnet. Die metallische Verstärkungsschicht 14 weist vorteilhaft eine Dicke von mindestens 5 um, besonders bevorzugt von mindestens 10 µm, auf. Die metallische Verstärkungsschicht 14 enthält ein Metall oder eine Metalllegierung, beispielsweise Nickel oder Kupfer. Vorzugsweise wird die Verstärkungsschicht 14 durch galvanische Abscheidung hergestellt. Die Verstärkungsschicht 14 weist vorzugsweise eine rms-Rauheit von mindestens 50 nm, besonders bevorzugt von mindestens 200 nm, auf. Die vergleichsweise große Rauheit der Verstärkungsschicht 14 hat den Vorteil, dass die Haftung einer ihr in Richtung 10 des Trägers nachfolgenden weiteren elektrisch isolierenden Schicht 15 verbessert wird.

Die elektrisch isolierende Schicht 15 zwischen dem Träger 10 und der Verstärkungsschicht 14 verbessert die Haftung des Kunststoffmaterials des Trägers 10 an dem optoelektronischen Bauelement.

Die Seitenflanken 21 der Halbleiterschichtenfolge 2 werden zumindest bereichsweise, vorzugsweise vollständig, von einer Schichtenfolge, welche eine oder mehrere elektrisch isolierende Schichten 13, 15 und eine oder mehrere metallische Schichten 8, 14, umfasst, bedeckt. Insbesondere grenzen die Seitenflanken 21 der Halbleiterschichtenfolge 2 nicht direkt an den Träger 10 an. Das Kunststoffmaterial des Trägers 10 wird auf diese Weise vorteilhaft vor der in der aktiven Schicht 4 erzeugten Strahlung geschützt. Bevorzugt ist die metallische Verstärkungsschicht 14, welche vorteilhaft eine Dicke von mindestens 5 µm aufweist, zumindest bereichsweise zwischen den Seitenflanken 21 der Halbleiterschichtenfolge 2 und dem Trägerkörper 10 angeordnet. Zusätzlich zum Schutz des Trägerkörpers 10 vor der Strahlung der aktiven Schicht 3 wird auf diese Weise auch eine Verbesserung der mechanischen Stabilität erreicht. Die Langzeitstabilität des optoelektronischen Halbleiterbauelements 100 wird auf diese Weise verbessert.

Die elektrisch isolierende Schicht 15 bewirkt eine elektrische Isolierung der Verstärkungsschicht 14 von der p-Kontaktdurchführung 7 und von der ersten Durchkontaktierung 11. Die elektrisch isolierende Schicht 15 weist zum Beispiel ein anorganisches Dielektrikum auf und ist vorzugsweise weniger als 5 µm dick. Die p-Kontaktdurchführung 7 und die Verstärkungsschicht 14 sind zumindest bereichsweise nur durch die elektrisch isolierende Schicht 15 voneinander getrennt. Insbesondere ist die p-Kontaktdurchführung 7 in vertikaler Richtung durch die Verstärkungsschicht 14 hindurch geführt, wobei die Verstärkungsschicht 14 bei dem dargestellten Ausführungsbeispiel mit der n-Kontaktschicht 8 elektrisch leitend verbunden ist und deshalb mittels der elektrisch isolierenden Schicht 15 von der p-Kontaktdurchführung 7 isoliert werden muss. Die mindestens eine p-Kontaktdurchführung 7 ist in lateraler Richtung vorzugsweise von dem mindestens einen n-Durchgangskontakt 8A, der zum n-Typ-Halbleiterbereich 5 führt, beabstandet. Anders ausgedrückt liegen die mindestens eine p-Kontaktdurchführung 7 und der mindestens eine n-Durchgangskontakt 8A nicht vertikal übereinander.

Die metallische Verstärkungsschicht 14 kann zumindest bereichsweise an die n-Kontaktschicht 8 angrenzen und auf diese Weise eine elektrisch leitende Verbindung zwischen der zweiten Durchkontaktierung 12 und der n-Kontaktschicht 8 ausbilden. Insbesondere kann sich ein Teil der zweiten Durchkontaktierung 12 durch die elektrisch isolierende Schicht 15 hindurch erstrecken und an die metallische Verstärkungsschicht 14 angrenzen, um diese elektrisch zu kontaktieren. Mit anderen Worten ist die zweite Durchkontaktierung 12 über die metallische Verstärkungsschicht 14 und die n-Kontaktschicht 8, 8A mit dem n-Typ Halbleiterbereich 5 elektrisch leitend verbunden.

An der Strahlungsaustrittsfläche 16 der Halbleiterschichtenfolge 2 ist bei dem dargestellten Ausführungsbeispiel eine Konverterschicht 20 angeordnet. Die Konverterschicht 20 kann insbesondere zumindest bereichsweise direkt an die Halbleiterschichtenfolge 2 angrenzen und ist insbesondere nicht durch ein Dielektrikum von der Halbleiterschichtenfolge 2 getrennt. Mittels der Konverterschicht 20 wird vorteilhaft zumindest ein Teil der von der aktiven Schicht 4 emittierten Strahlung in Strahlung mit einer größeren Wellenlänge konvertiert. Auf diese Weise kann beispielsweise mit einem im blauen oder UV-Spektralbereich emittierenden Halbleiterchip Weißlicht erzeugt werden. Die Konverterschicht 20 weist hierzu vorteilhaft einen oder mehrere Konversionsstoffe auf, die beispielsweise in ein Matrixmaterial, zum Beispiel ein Silikon, eingebettet sein können. Das Prinzip der Lumineszenzkonversion und geeignete Konversionsstoffe sind dem Fachmann bekannt und werden daher an dieser Stelle nicht näher erläutert.

Die Konverterschicht 20 erstreckt sich in lateraler Richtung um eine Länge L, die vorzugsweise mindestens 5 µm und höchstens 50 µm beträgt, über die Halbleiterschichtenfolge 2 hinaus. Auf diese Weise kann vorteilhaft eine verbesserte Farbhomogenität der emittierten Strahlung erzielt werden und/oder der Farbort der emittierten Strahlung in Abhängigkeit vom Abstrahlwinkel gezielt eingestellt werden.

Das optoelektronische Bauelement 100 weist schräge Seitenflanken 22 auf. Die Seitenflanken 22 sind insbesondere um einen Winkel, der ungleich 90° ist, zu einer Hauptebene der Halbleiterschichtenfolge 2 geneigt. Die schrägen Seitenflanken 22 sind derart geneigt, dass sich das optoelektronische Bauelement 100 in einer vom Träger zur Strahlungsaustrittsfläche 16 hin verlaufenden Richtung verjüngt. Das optoelektronische Bauelement 100 ist also an einer Rückseite, welche durch die zweite Hauptfläche 18 des Trägers 10 gebildet sein kann, breiter als an einer Vorderseite, an welcher die Strahlungsaustrittsfläche 16 und gegebenenfalls die Konverterschicht 20 angeordnet sind. Die schräge Ausbildung der Seitenflanken 22 hat den Vorteil, dass beim Greifen des optoelektronischen Halbleiterbauteils 100 von der Seite nicht die Gefahr besteht, dass das Greifwerkzeug in Kontakt mit der Konverterschicht 20 kommt. Auf diese Weise wird die Gefahr vermindert, dass das Greifwerkzeug durch die beispielsweise ein klebriges Silikon umfassende Konverterschicht 20 verunreinigt wird.

Das optoelektronische Bauelement 100 wird vorzugsweise in einem Waferverbund mit einer Vielzahl weiterer gleichartiger optoelektronischer Bauelement hergestellt. Die schrägen Seitenflanken 22 werden vorzugsweise beim Zertrennen des Wafers in einzelne optoelektronische Bauelemente 100 erzeugt. Das Zertrennen kann beispielsweise durch Sägen oder durch Lasertrennen erfolgen.

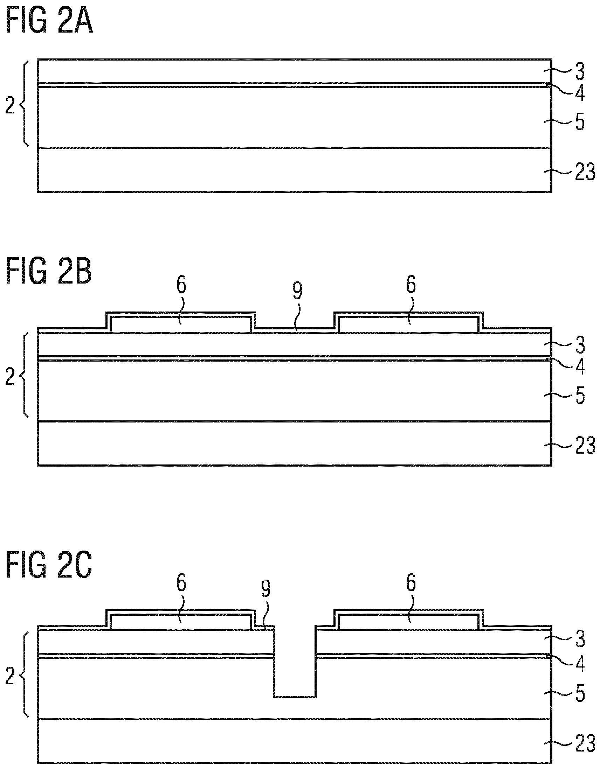

In den folgenden Figuren 2A bis 2M wird ein Ausführungsbeispiel eines Verfahrens zur Herstellung des optoelektronischen Halbleiterbauelements beschrieben. Die zuvor beschriebenen vorteilhaften Ausgestaltungen einzelner Bestandteile des optoelektronischen Halbleiterbauelements gelten in gleicher Weise für das im Folgenden beschriebene Verfahren und umgekehrt.

Bei dem in Figur 2A dargestellten Zwischenschritt des Verfahrens ist die Halbleiterschichtenfolge 2, die den p-Typ Halbleiterbereich 3, die aktive Schicht 4 und den n-Typ Halbleiterbereich 5 umfasst, auf ein Aufwachssubstrat 23 aufgewachsen worden. Das Aufwachssubstrat 23 kann beispielsweise GaN, Saphir, GaAs, Si oder SiC aufweisen. Die Halbleiterschichtenfolge 2 wird vorzugsweise epitaktisch, insbesondere mittels metallorganischer Gasphasenepitaxie (MOVPE) hergestellt. Der p-Typ Halbleiterbereich 3, die aktive Schicht 4 und der n-Typ Halbleiterbereich 5 können jeweils aus mehreren Einzelschichten zusammengesetzt sein, die zur Vereinfachung nicht im Einzelnen dargestellt sind.

Bei dem in Figur 2B dargestellten Zwischenschritt ist eine p-Kontaktschicht 6 auf die Halbleiterschichtenfolge 2 aufgebracht und in Teilbereiche strukturiert worden. Die p-Kontaktschicht 6 weist vorzugsweise ein Metall oder eine Metalllegierung auf und kann insbesondere eine reflektierende Schicht sein. Die p-Kontaktschicht 6 kann beispielsweise Silber aufweisen oder daraus bestehen. Es ist auch möglich, dass die p-Kontaktschicht 6 aus mehreren Teilschichten gebildet ist. Weiterhin ist eine Verkapselungsschicht 9 über der p-Kontaktschicht 6 aufgebracht worden. Die Verkapselungsschicht 9 ist vorzugsweise eine anorganische dielektrische Schicht, insbesondere eine Oxid- oder Nitridschicht wie beispielsweise eine Siliziumoxidschicht oder eine Siliziumnitridschicht. Alternativ kann die Verkapselungsschicht beispielsweise TiWN, TiN, TiW oder Cr enthalten. Die Verkapselungsschicht 9 dient zum Beispiel zur elektrischen Isolierung der p-Kontaktschicht 6 gegenüber nachfolgenden elektrisch leitenden Schichten, insbesondere einer n-Kontaktschicht, und/oder zum Schutz der p-Kontaktschicht 6.

Bei dem in Figur 2C dargestellten Zwischenschritt ist beispielsweise mit einem Ätzprozess eine Ausnehmung in der Halbleiterschichtenfolge 2 erzeugt worden, welche sich bis in den n-Typ Halbleiterbereich 5 hinein erstreckt. Die Ausnehmung dient im weiteren Verfahren zur Durchführung einer n-Kontaktschicht in den n-Typ Halbleiterbereich 5.

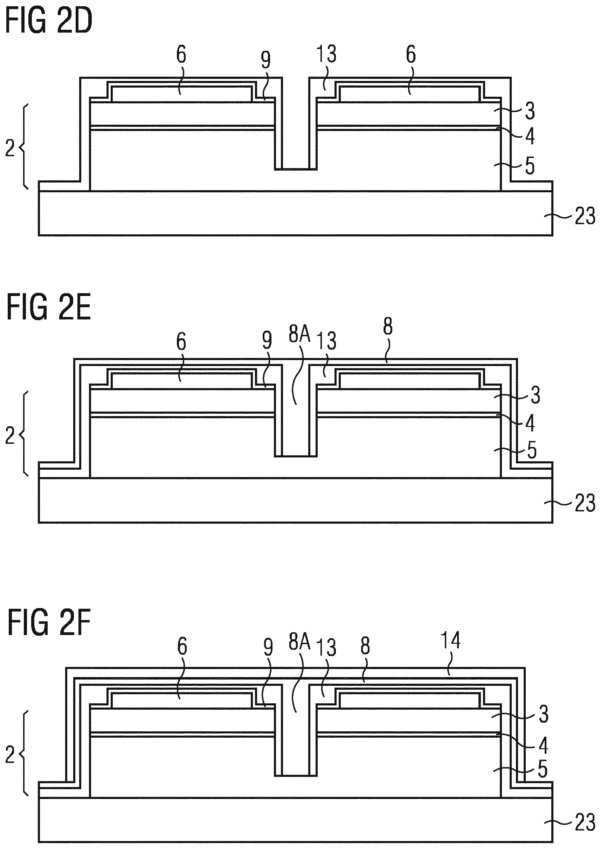

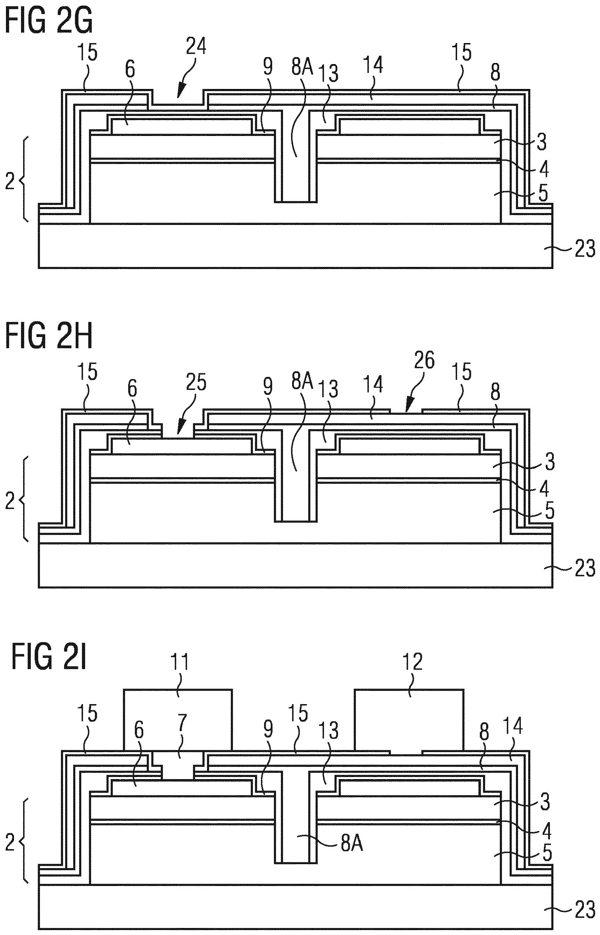

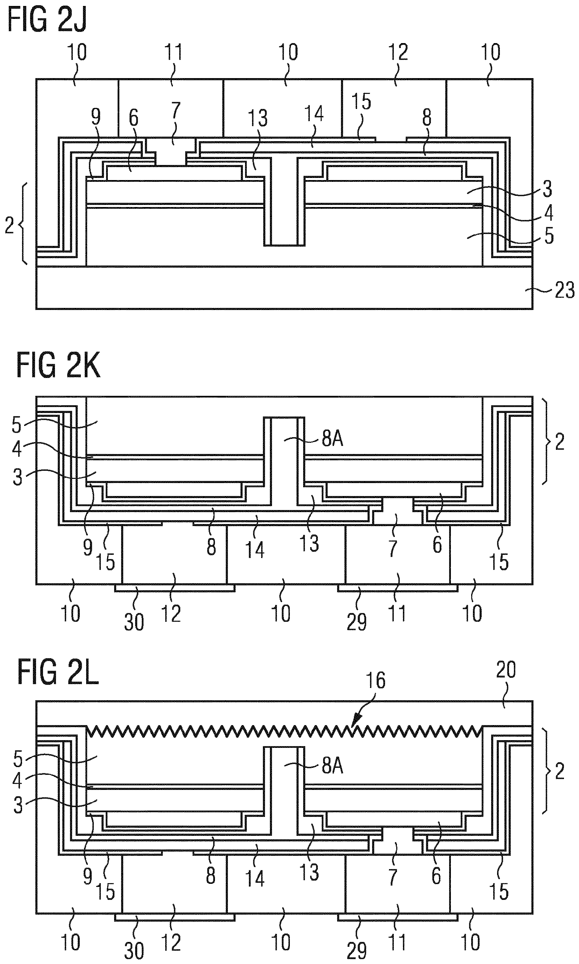

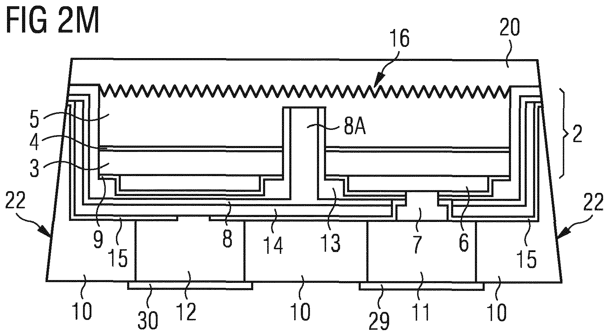

Bei dem in Figur 2D dargestellten Zwischenschritt ist eine Mesastruktur in der Halbleiterschichtenfolge 2 erzeugt worden. Hierzu ist die Halbleiterschichtenfolge 2 im Randbereich beispielsweise mit einem Ätzprozess abgetragen worden, um sie zu einer gewünschten Form und Größe zu strukturieren. Die Mesastruktur erstreckt sich vorzugsweise bis in den Bereich des Aufwachssubstrats 23, d.h. die Halbleiterschichtenfolge 2 wird in den Randbereichen fast vollständig oder vollständig abgetragen. Außerdem ist bei dem in Figur 2 dargestellten Zwischenschritt eine weitere elektrisch isolierende Schicht 13 aufgebracht worden, welche insbesondere die Seitenflanken der Halbleiterschichtenfolge 2 in den Ätzgräben der Mesastruktur und der Ausnehmung bedeckt und auf diese Weise elektrisch isoliert. Am Boden der Ausnehmung, die im vorherigen Zwischenschritt zur späteren Durchführung der n-Kontaktschicht hergestellt wurde, ist die elektrisch isolierende Schicht 13 entfernt worden, um den n-Typ Halbleiterbereich 5 dort freizulegen.

Bei dem in Figur 2E dargestellten Zwischenschritt ist eine n-Kontaktschicht 8 aufgebracht worden. Die n-Kontaktschicht 8 weist vorzugsweise ein Metall oder eine Metalllegierung auf. Insbesondere kann die n-Kontaktschicht 8 ein reflektierendes Metall wie beispielsweise Aluminium oder Silber aufweisen. Im Bereich der Ausnehmung erstreckt sich die n-Kontaktschicht 8 durch den p-Typ Halbleiterbereich 3 und die aktive Schicht 4 hindurch bis in den n-Typ Halbleiterbereich 5 und bildet in diesem Bereich einen Durchgangskontakt 8A aus. Die n-Kontaktschicht 8 kann an den Seitenflanken der Halbleiterschichtenfolge 2 die zuvor aufgebrachte elektrisch isolierende Schicht 13 bedecken.

Bei dem in Figur 2F dargestellten Zwischenschritt ist eine metallische Verstärkungsschicht 14 aufgebracht worden. Die metallische Verstärkungsschicht 14 ist aus einem Metall oder einer Metalllegierung gebildet und kann insbesondere galvanisch aufgebracht werden. Die Verstärkungsschicht 14 kann zum Beispiel Nickel enthalten. Zur galvanischen Herstellung der metallischen Verstärkungsschicht 14 kann zuvor eine Startschicht (seed layer) aufgebracht und gegebenenfalls strukturiert werden (nicht dargestellt). Um die metallische Verstärkungsschicht strukturiert aufzubringen, können außerdem an sich bekannte fotolithografische Schritte, insbesondere unter Verwendung einer Lackmaske, eingesetzt werden.

Vorzugsweise ist die Verstärkungsschicht 14 mindestens 5 um, besonders bevorzugt mindestens 10 µm dick. Die Verstärkungsschicht 14 ist insbesondere auch zumindest teilweise seitlich von der Halbleiterschichtenfolge 2 angeordnet. Durch die Verstärkungsschicht 14 erhöht sich die mechanische Stabilität bei nachfolgenden Prozessschritten und insbesondere im fertigen optoelektronischen Bauelement.

Bei dem in Figur 2G dargestellten Zwischenschritt ist mindestens eine Öffnung 24 in der Verstärkungsschicht 14 und der darunter liegenden n-Kontaktschicht 8 erzeugt worden, wobei sich die Öffnung 24 beispielsweise bis zur elektrisch isolierenden Schicht 13 erstreckt. Alternativ wäre es auch möglich, die metallische Verstärkungsschicht 14 im Verfahrensschritt der Fig. 2F bereits derart strukturiert aufzubringen, dass sie eine oder mehrere Öffnungen 24 aufweist. Weiterhin ist über der Verstärkungsschicht 14 eine weitere elektrisch isolierende Schicht 15 aufgebracht worden, welche wie die zuvor beschriebene Verkapselungsschicht 9 oder die elektrisch isolierende Schicht 13 vorzugsweise mindestens ein anorganisches Dielektrikum wie beispielsweise Siliziumoxid aufweisen kann. Die elektrisch isolierende Schicht 15 bedeckt die Oberfläche der Verstärkungsschicht 14 vorzugsweise vollständig. Insbesondere werden die elektrisch leitenden Schichten 8, 14 im Bereich der Öffnung 24 von der elektrisch isolierenden Schicht 15 bedeckt.

Die elektrisch isolierende Schicht 15 ist vorzugsweise eine Siliziumdioxidschicht, die vorteilhaft mittels CVD unter Verwendung von Tetraethylorthosilikat hergestellt wird. Es hat sich herausgestellt, dass mit diesem Verfahren vorteilhaft erreicht werden kann, dass die elektrisch isolierende Schicht 15 die Verstärkungsschicht 14 konform bedeckt. Die elektrisch isolierende Schicht 15 weist somit vorteilhaft im Wesentlichen dieselbe Rauheit auf wie die Verstärkungsschicht 14. Vorzugsweise beträgt die rms-Rauheit der elektrisch isolierenden Schicht 15 mindestens 50 nm, bevorzugt mindestens 100 nm. Die elektrisch isolierende Schicht 15 bedeckt die Verstärkungsschicht 14 insbesondere konform im Bereich der mindestens einen Öffnung 24, um dort eine elektrische Isolierung zu bewirken.

Bei dem in Figur 2H dargestellten Zwischenschritt sind mindestens eine Öffnung 25 in den elektrisch isolierenden Schichten 13, 15 und der Verkapselungsschicht 9 zur Freilegung der p-Kontaktschicht 6 und mindestens eine weitere Öffnung 26 in der elektrisch isolierenden Schicht 15 zur Freilegung eines Bereich der Verstärkungsschicht 14 erzeugt worden.

Bei dem in Figur 2I dargestellten Zwischenschritt ist die zuvor erzeugte Öffnung über der p-Kontaktschicht 6 mit einer metallischen Schicht, die einen p-Durchgangskontakt 7 ausbildet, aufgefüllt worden. Der p-Durchgangskontakt 7 ist mit einer metallischen Kontaktschicht, die im fertigen Bauelement eine erste Durchkontaktierung 11 durch einen Träger ausbildet, verbunden. Die erste Durchkontaktierung 11 ist auf diese Weise über den p-Durchgangskontakt 7 und die p-Kontaktschicht 6 mit dem p-Typ Halbleiterbereich 3 elektrisch leitend verbunden. Weiterhin ist bei dem Zwischenschritt eine zweite metallische Kontaktschicht, die im fertigen Bauelement eine zweite Durchkontaktierung 12 durch einen Träger ausbildet, über der zuvor hergestellten Öffnung in der elektrisch isolierenden Schicht 15, die über der Verstärkungsschicht 14 angeordnet ist, hergestellt worden. Die zweite Durchkontaktierung 12 wird auf diese Weise elektrisch leitend mit der Verstärkungsschicht 14 verbunden und kontaktiert auf diese Weise über die n-Kontaktschicht 8 mit dem Durchgangskontakt 8A den n-Typ Halbleiterbereich 3.

Es ist möglich, dass die erste Durchkontaktierung 11, die zweite Durchkontaktierung 12 und/oder der p-Durchgangskontakt 7 in einem Verfahrensschritt galvanisch hergestellt werden. Der p-Durchgangskontakt 7 und die Verstärkungsschicht 14 sind zumindest bereichsweise in einer Ebene angeordnet und nur durch einen Bereich der elektrisch isolierenden Schicht 15, die vorzugsweise weniger als 5 um dick ist, voneinander getrennt.

Es ist möglich, dass anstelle einer einzigen p-Kontaktdurchführung 7 mehrere p-Kontaktdurchführungen 7 zwischen der ersten Durchkontaktierung 11 und der p-Kontaktschicht 6 erzeugt werden (nicht dargestellt). Bei dieser Variante werden in den vorherigen Zwischenschritten mehrere Öffnungen in der Verstärkungsschicht 14, der n-Kontaktschicht 8, der elektrisch isolierenden Schicht 13 und der Verkapselungsschicht 9 erzeugt. Die mindestens eine p-Kontaktdurchführung 7 kann in Draufsicht beispielsweise einen kreisförmigen Querschnitt aufweisen. Wenn mehrere p-Kontaktdurchführungen 7 ausgebildet werden, können diese beispielsweise eine Anordnung mehrerer Kreise ausbilden. Die mindestens eine p-Kontaktdurchführung 7 muss nicht notwendigerweise senkrecht verlaufen, sondern kann alternativ auch schräg zur vertikalen Richtung verlaufen und/oder Seitenflanken mit einer geschwungenen Form aufweisen. Dies verbessert die Haftung der p-Kontaktdurchführung 7 an der elektrisch isolierenden Schicht 15, durch welche die p-Kontaktdurchführung 7 verläuft, und die Überformung der elektrisch isolierenden Schicht 15.

Bei dem in Figur 2J dargestellten Zwischenschritt ist die vom Aufwachssubstrat 23 abgewandte Seite des optoelektronischen Bauelements mit einem Kunststoffmaterial umformt worden, um auf diese Weise einen Träger 10 auszubilden. Der Träger 10 kann insbesondere ein Polymer wie zum Beispiel ein mit SiO2 gefülltes Epoxid, ein Silikon oder ein Hybridmaterial aufweisen. Falls beim Aufbringen des Kunststoffmaterials des Trägers 10 die Durchkontaktierungen 11, 12 überdeckt werden, werden diese wieder freigelegt, zum Beispiel durch Schleifen, Läppen, Polieren, andere mechanische Bearbeitungsschritte, Laserablation, Ätzen oder eine Kombination mehrerer solcher Verfahrensschritte. Vorzugsweise werden die Durchkontaktierungen 11, 12 beim Abtragen des Kunststoffmaterials selbst mit angeschliffen.

Bei dem in Figur 2K dargestellten Zwischenschritt ist das Aufwachsubstrat 23 von der Halbleiterschichtenfolge 2 abgelöst worden. Das Ablösen des Aufwachssubstrats 23 kann zum Beispiel mittels eines Laser-Lift-Off Verfahrens, Ätzen oder Schleifen erfolgen. Das optoelektronische Halbleiterbauelement ist nun im Vergleich zu den vorherigen Zwischenschritten kopfüber dargestellt, weil nun die Oberfläche der Halbleiterschichtenfolge 2 die Vorderseite und der Träger 10 die Rückseite des optoelektronischen Halbleiterbauelements darstellt. Außerdem sind die Rückseiten der Durchkontaktierungen 11, 12 mit Rückseitenkontakten 29, 30 versehen worden.

Bei dem weiteren in Figur 2L dargestellten Zwischenschritt ist die Oberfläche der Halbleiterschichtenfolge 2, die als Strahlungsaustrittsfläche 16 fungiert, aufgeraut worden, um insbesondere die Strahlungsauskopplung zu verbessern. Weiterhin ist eine Konverterschicht 20 aufgebracht worden, zum Beispiel durch Vergießen, Formpressen, Sprühbeschichten oder Auflaminieren einer Konverterfolie. Die Konverterschicht 20 steht in seitlicher Richtung vorzugsweise mindestens 5 µm über die Halbleiterschichtenfolge 2 über. Beispielsweise kann die Konverterschicht in seitlicher Richtung zwischen mindestens 5 µm und höchstens 50 um über die Halbleiterschichtenfolge 2 hinausragen. Die bis hierher beschriebenen Zwischenschritte werden vorzugsweise im Waferstadium durchgeführt, d.h. es wird eine Vielzahl gleichartiger optoelektronischer Halbleiterbauelemente gleichzeitig nebeneinander prozessiert.

Bei dem weiteren in Figur 2M dargestellten Verfahrensschritt sind schräge Seitenflanken 22 erzeugt worden, wobei dieser Prozessschritt insbesondere beim Vereinzeln eines Wafers in einzelne optoelektronische Bauelement erfolgen kann. Bei Vorhandensein einer Konverterschicht 20 erfolgt das Vereinzeln vorzugsweise durch Lasertrennen mit einem Pikosekunden-Laser oder durch einen wasserstrahlgeführten Prozess, um die thermische Belastung der Konverterschicht 20 möglichst gering zu halten. Auf diese Weise kann das in Figur 1 dargestellte optoelektronische Halbleiterbauelement 100 beispielhaft hergestellt werden.

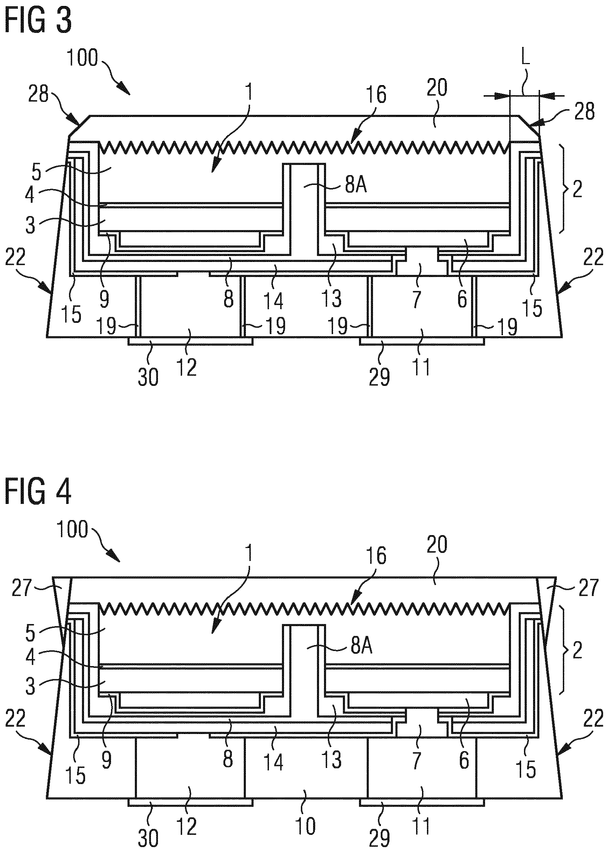

Das in Figur 3 dargestellte zweite Ausführungsbeispiel des optoelektronischen Halbleiterbauelements 100 unterscheidet sich von dem in Figur 1 dargestellten Ausführungsbeispiel dadurch, dass die Konverterschicht eine Fase 28, d.h. eine an der Außenseite der Oberfläche abgeschrägte Kante, aufweist. Die Fase kann zum Beispiel einen 45°-Winkel mit der Oberfläche der Konverterschicht 20 ausbilden. Alternativ kann die Konverterschicht 20 eine abgerundete Kante aufweisen. Auf diese Weise kann vorteilhaft die Homogenität (Farbe über Winkel) der emittierten Strahlung verbessert werden. Hinsichtlich weiterer Ausgestaltungen und der damit verbundenen Vorteile entspricht das zweite Ausführungsbeispiel dem ersten Ausführungsbeispiel.

Zwischen den Durchkontaktierungen 11, 12 und dem Träger 10 ist vorteilhaft jeweils eine elektrisch isolierende Schicht 19 angeordnet. Auf diese Weise wird die Haftung des Kunststoffmaterials des Trägers 10 an den metallischen Durchkontaktierungen 11, 12 verbessert. Die elektrisch isolierende Schicht 19 weist ein dielektrisches Material auf, das sich von dem Material des Trägers unterscheidet. Insbesondere kann die elektrisch isolierende Schicht 19 ein anorganisches dielektrisches Material aufweisen.

Bei dem in Figur 4 dargestellten dritten Ausführungsbeispiel des optoelektronischen Halbleiterbauelements 100 ist auf die Seitenflächen der Konverterschicht 20 eine lichtabsorbierende oder reflektierende Schicht 27 aufgebracht worden. Auf diese Weise wird eine seitliche Abstrahlung durch die Konverterschicht 20 vermindert und auf diese Weise die Farbhomogenität der emittierten Strahlung verbessert. Die lichtabsorbierende Schicht 27 weist eine variierende Dicke auf, die zu einer Oberfläche der Konverterschicht 20 hin zunimmt. Auf diese Weise wird das am oberen Rand der Konverterschicht 20 emittierte Licht, das einen besonders langen Weg durch die Konverterschicht 20 zurückgelegt hat und deshalb einen besonders hohen Anteil an konvertiertem Licht aufweist, stärker geschwächt, um beispielsweise einen gelblichen Farbdruck zu vermindern.

Weiterhin unterscheidet sich das in Fig. 4 dargestellte Ausführungsbeispiel dadurch von dem Ausführungsbeispiel der Fig. 1, dass die n-Kontaktschicht 8 an keiner Stelle an die Seitenflanken 22 des optoelektronischen Halbleiterchips angrenzt. Dies ist insbesondere dann vorteilhaft, wenn die n-Kontaktschicht 8 ein gegenüber Umgebungseinflüssen wie insbesondere Feuchtigkeit empfindliches Metall wie zum Beispiel Silber aufweist. Um sicherzustellen, dass die n-Kontaktschicht 8 im fertigen optoelektronischen Halbleiterbauelement 100 nicht an die Chipflanken angrenzt, wird die n-Kontaktschicht 8 zum Beispiel bei dem Verfahrensschritt der Fig. 2E derart strukturiert aufgebracht, dass sie in lateraler Richtung nicht bis an die Seitenflanken des Aufwachssubstrats 23 heranreicht und so bei den nachfolgenden Verfahrensschritten seitlich insbesondere von der dielektrischen Schicht 15 überdeckt wird.

Hinsichtlich weiterer Ausgestaltungen und der damit verbundenen Vorteile entspricht das dritte Ausführungsbeispiel dem ersten Ausführungsbeispiel.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

### Bezugszeichenliste

- 1: Halbleiterkörper
- 2: Halbleiterschichtenfolge
- 3: p-Typ Halbleiterbereich
- 4: aktive Schicht
- 5: n-Typ Halbleiterbereich
- 6: p-Kontaktschicht
- 7: p-Durchkontaktierung
- 8: n-Kontaktschicht
- 8A: n-Durchgangskontakt
- 9: Verkapselungsschicht
- 10: Träger
- 11: erste Durchkontaktierung
- 12: zweite Durchkontaktierung
- 13: elektrisch isolierende Schicht
- 14: Verstärkungsschicht
- 15: elektrisch isolierende Schicht
- 16: Strahlungsaustrittsfläche
- 17: erste Hauptfläche
- 18: zweite Hauptfläche
- 19: elektrisch isolierende Schicht
- 20: Konverterschicht
- 21: Seitenflanke der Halbleiterschichtenfolge
- 22: Seitenflanke des Halbleiterbauelements
- 23: Aufwachssubstrat
- 24: Öffnung
- 25: Öffnung
- 26: Öffnung
- 27: lichtabsorbierende oder reflektierende Schicht
- 28: Fase
- 29: Rückseitenkontakt
- 30: Rückseitenkontakt
- 100: optoelektronisches Halbleiterbauelement

## Patentansprüche

1. Optoelektronisches Halbleiterbauelement (100), umfassend
- einen Halbleiterkörper (1), der eine Halbleiterschichtenfolge (2) mit einem p-Typ Halbleiterbereich (3), einem n-Typ Halbleiterbereich (5) und einer zwischen dem p-Typ Halbleiterbereich (3) und dem n-Typ Halbleiterbereich (5) angeordneten aktiven Schicht (4) aufweist,
- einen Träger (10), der einen Kunststoff aufweist und eine erste Durchkontaktierung (11) und eine zweite Durchkontaktierung (12) aufweist,
- eine p-Kontaktschicht (6) und eine n-Kontaktschicht (8, 8A), welche zumindest bereichsweise zwischen dem Träger (10) und dem Halbleiterkörper (1) angeordnet sind, wobei die p-Kontaktschicht (6) elektrisch leitend mit der ersten Durchkontaktierung (11) und dem p-Typ Halbleiterbereich (3) verbunden ist, und die n-Kontaktschicht (8, 8A) elektrisch leitend mit der zweiten Durchkontaktierung (12) und dem n-Typ Halbleiterbereich (5) verbunden ist,
- eine metallische Verstärkungsschicht (14), welche zumindest bereichsweise zwischen der n-Kontaktschicht (8) und dem Träger (10) angeordnet ist, wobei die metallische Verstärkungsschicht (14) mindestens 5 µm dick ist, und
- mindestens eine p-Kontaktdurchführung (7), welche zwischen der ersten Durchkontaktierung (11) und der p-Kontaktschicht (6) angeordnet ist, wobei die p-Kontaktdurchführung (7) mindestens 5 µm dick ist und in lateraler Richtung zumindest bereichsweise von der Verstärkungsschicht (14) umgeben ist, wobei
- das optoelektronische Halbleiterbauelement (100) schräge Seitenflanken (22) aufweist, die zumindest bereichsweise von Außenseiten des Trägers (10) gebildet sind, und wobei die Seitenflanken (22) derart schräg verlaufen, dass sich ein Querschnitt des optoelektronischen Halbleiterbauelements (100) vom Träger (10) zu einer Strahlungsaustrittsfläche (16) hin verjüngt.

2. Optoelektronisches Halbleiterbauelement nach Anspruch 1,
wobei die metallische Verstärkungsschicht (14) Nickel oder Kupfer aufweist oder daraus besteht.

3. Optoelektronisches Halbleiterbauelement nach einem der vorhergehenden Ansprüche,
wobei die metallische Verstärkungsschicht (14) an einer dem Träger zugewandten Grenzfläche eine rms-Rauheit von mindestens 50 nm aufweist.

4. Optoelektronisches Halbleiterbauelement nach einem der vorhergehenden Ansprüche,
wobei zwischen dem Träger (10) und der metallischen Verstärkungsschicht (14) eine dielektrische Schicht (15) angeordnet ist.

5. Optoelektronisches Halbleiterbauelement nach Anspruch 4,
wobei die dielektrische Schicht (15) zumindest teilweise zwischen der metallischen Verstärkungsschicht (14) und der p-Kontaktdurchführung (7) angeordnet ist.

6. Optoelektronisches Halbleiterbauelement nach einem der vorhergehenden Ansprüche,
wobei die Halbleiterschichtenfolge (2) in lateraler Richtung zumindest bereichsweise von dem Träger (10) umgeben ist.

7. Optoelektronisches Halbleiterbauelement nach Anspruch 6,
wobei die Verstärkungsschicht (14) in lateraler Richtung gesehen bereichsweise zwischen der Halbleiterschichtenfolge (2) und dem Träger (10) angeordnet ist.

8. Optoelektronisches Halbleiterbauelement nach einem der vorhergehenden Ansprüche,
wobei an einer Strahlungsaustrittsfläche (16) des optoelektronischen Halbleiterbauelements (100) eine Konverterschicht (20) angeordnet ist.

9. Optoelektronisches Halbleiterbauelement nach Anspruch 8,
wobei die Konverterschicht (20) in lateraler Richtung um eine Länge L von mindestens 5 µm über die Halbleiterschichtenfolge (2) übersteht.

10. Optoelektronisches Halbleiterbauelement nach Anspruch 8 oder 9,
wobei die Konverterschicht (20) eine Fase (28) aufweist.

11. Optoelektronisches Halbleiterbauelement nach einem der Ansprüche 8 bis 10,
wobei Seitenflächen der Konverterschicht (20) mit einer lichtabsorbierenden oder reflektierenden Schicht (27) bedeckt sind.

12. Optoelektronisches Halbleiterbauelement nach Anspruch 11,
wobei die lichtabsorbierende Schicht (27) eine zur Oberfläche der Konverterschicht (20) hin zunehmende Dicke aufweist.

13. Optoelektronisches Halbleiterbauelement nach einem der vorhergehenden Ansprüche,
wobei der Träger (10) ein Epoxidharz oder ein Silikon aufweist.

14. Optoelektronisches Halbleiterbauelement nach einem der vorhergehenden Ansprüche,
wobei die n-Kontaktschicht (8, 8A) mindestens einen n-Durchgangskontakt (8A) aufweist, der durch einen Durchbruch in dem p-Typ-Halbleiterbereich (3) und der der aktiven Schicht (4) in den n-Typ Halbleiterbereich (5) geführt ist.

15. Optoelektronisches Halbleiterbauelement nach einem der vorhergehenden Ansprüche,
wobei die mindestens eine p-Kontaktdurchführung (7) von dem mindestens einen n-Durchgangskontakt (8A) in lateraler Richtung beabstandet ist.

16. Optoelektronisches Halbleiterbauelement nach einem der vorhergehenden Ansprüche,
wobei die p-Kontaktschicht (6) bereichsweise von einer anorganischen dielektrischen Verkapselungsschicht (9) bedeckt ist.

17. Verfahren zur Herstellung eines optoelektronischen Halbleiterbauelements (100) gemäß einem der vorhergehenden Ansprüche,
wobei die Verstärkungsschicht (14) und die p-Kontaktdurchführung (7) durch galvanische Abscheidung hergestellt werden.

18. Verfahren nach Anspruch 17 unter Rückbezug auf mindestens Anspruch 4,
wobei die dielektrische Schicht (15) eine Siliziumoxidschicht ist und mittels CVD aus Tetraethylorthosilikat hergestellt wird.

## Claims

1. An optoelectronic semiconductor component (100), comprising
- a semiconductor body (1), which comprises a semiconductor layer sequence (2) having a p-type semiconductor region (3), an n-type semiconductor region (5) and an active layer (4) arranged between the p-type semiconductor region (3) and the n-type semiconductor region (5),
- a carrier (10), which comprises a plastic and a first via (11) and a second via (12),
- a p-contact layer (6) and an n-contact layer (8, 8A), which are arranged between the carrier (10) and the semiconductor body (1) at least in some regions, wherein the p-contact layer (6) is electrically joined to the first via (11) and the p-type semiconductor region (3), and the n-contact layer (8, 8A) is electrically joined to the second via (12) and the n-type semiconductor region (5),
- a metallic reinforcing layer (14), which is arranged at least in some regions between the n-contact layer (8) and the carrier (10), wherein the metallic reinforcing layer (14) is at least 5 µm thick, and
- at least one p-contact feed-through (7), which is arranged between the first via (11) and the p-contact layer (6), wherein the p-contact feed-through (7) is at least 5 µm thick and is surrounded in a lateral direction by the reinforcing layer (14) at least in some regions, wherein
- the optoelectronic semiconductor component (100) comprises oblique side walls (22), which are formed at least in some regions by external sides of the carrier (10), and wherein the side walls (22) run obliquely in such a way that a cross-section of the optoelectronic semiconductor component (100) tapers from the carrier (10) towards a radiation exit surface (16).

2. The optoelectronic semiconductor component according to claim 1,
wherein the metallic reinforcing layer (14) comprises or consists of nickel or copper.

3. The optoelectronic semiconductor component according to one of the preceding claims,
wherein the metallic reinforcing layer (14) has an RMS roughness of at least 50 nm at an interface facing towards the carrier.

4. The optoelectronic semiconductor component according to one of the preceding claims,
wherein a dielectric layer (15) is arranged between the carrier (10) and the metallic reinforcing layer (14).

5. The optoelectronic semiconductor component according to claim 4,
wherein the dielectric layer (15) is arranged at least partly between the metallic reinforcing layer (14) and the p-contact feed-through (7).

6. The optoelectronic semiconductor component according to one of the preceding claims,
wherein the semiconductor layer sequence (2) is surrounded by the carrier (10) in a lateral direction, at least in some regions.

7. The optoelectronic semiconductor component according to claim 6,
wherein the reinforcing layer (14) is arranged between the semiconductor layer sequence (2) and the carrier (10) in some regions when viewed in a lateral direction.

8. The optoelectronic semiconductor component according to one of the preceding claims,
wherein a converter layer (20) is arranged on a radiation exit surface (16) of the optoelectronic semiconductor component (100).

9. The optoelectronic semiconductor component according to claim 8,
wherein the converter layer (20) projects over the semiconductor layer sequence (2) by a length L of at least 5 µm in a lateral direction.

10. The optoelectronic semiconductor component according to claim 8 or 9,
wherein the converter layer (20) comprises a chamfer (28) .

11. The optoelectronic semiconductor component according to one of claims 8 to 10,
wherein side surfaces of the converter layer (20) are covered with a light-absorbing or reflective layer (27).

12. The optoelectronic semiconductor component according to claim 11,
wherein the light-absorbing layer (27) has a thickness that increases towards the surface of the converter layer (20) .

13. The optoelectronic semiconductor component according to one of the preceding claims,
wherein the carrier (10) comprises an epoxy resin or a silicone.

14. The optoelectronic semiconductor component according to one of the preceding claims,
wherein the n-contact layer (8, 8A) comprises at least one n-through-contact (8A), which is routed through a gap in the p-type-semiconductor region (3) and the active layer (4) into the n-type semiconductor region (5).

15. The optoelectronic semiconductor component according to one of the preceding claims,
wherein the at least one p-contact feed-through (7) is at a distance from the at least one n-through-contact (8A) in a lateral direction.

16. The optoelectronic semiconductor component according to one of the preceding claims,
wherein the p-contact layer (6) is covered in some regions by an inorganic dielectric encapsulating layer (9) .

17. A method for producing an optoelectronic semiconductor component (100) according to one of the preceding claims, wherein the reinforcing layer (14) and the p-contact feed-through (7) are produced by electroplating.

18. The method according to claim 17 with reference to at least claim 4,
wherein the dielectric layer (15) is a silicon oxide layer and is produced by means of CVD from tetraethyl orthosilicate.

## Revendications

1. Composant semiconducteur optoélectronique (100), comprenant
- un corps de semiconducteur (1), qui présente une succession de couches semiconductrices (2) avec une zone de semiconducteur de type p (3), une zone de semiconducteur de type n (5) et une couche active (4) disposée entre la zone de semiconducteur de type p (3) et la zone de semiconducteur de type n (5),
- un support (10), qui présente un plastique et présente un premier trou d'interconnexion (11) et un second trou d'interconnexion (12),
- une couche de contact p (6) et une couche de contact n (8, 8A), qui sont disposées au moins par zones entre le support (10) et le corps de semiconducteur (1), sachant que la couche de contact p (6) est reliée de manière électriquement conductrice avec le premier trou d'interconnexion (11) et la zone de semiconducteur de type p (3), et la couche de contact (8, 8A) est reliée de manière électriquement conductrice avec le second trou d'interconnexion (12) et la zone de semiconducteur de type n (5),
- une couche de renforcement métallique (14), qui est disposée au moins par zones entre la couche de contact n (8) et le support (10), sachant que la couche de renforcement métallique (14) fait au moins 5 µm d'épaisseur, et
- au moins une traversée de contact p (7), qui est disposée entre le premier trou d'interconnexion (11) et la couche de contact p (6), sachant que la traversée de contact p (7) fait au moins 5 µm d'épaisseur et est entourée dans la direction latérale au moins par zones de la couche de renforcement (14), sachant que
- le composant semiconducteur optoélectronique (100) présente des flancs latéraux inclinés (22), qui sont constitués au moins par zone par les côtés extérieurs du support (10), et sachant que les flancs latéraux (22) se produisent de manière inclinée telle qu'une section du composant semiconducteur optoélectronique (100) s'effile du support (10) vers une surface de sortie du rayonnement (16) .

2. Composant semiconducteur optoélectronique selon la revendication 1,
sachant que la couche de renforcement métallique (14) présente du nickel ou du cuivre ou est fabriquée à partir de ceux-ci.

3. Composant semiconducteur optoélectronique selon une quelconque des revendications précédentes,
sachant que la couche de renforcement métallique (14) présente sur une surface limite tournée vers le support une rugosité rms d'au moins 50 nm.

4. Composant semiconducteur optoélectronique selon une quelconque des revendications précédentes,
sachant qu'entre le support (10) et la couche de renforcement métallique (14) est disposée une couche diélectrique (15).

5. Composant semiconducteur optoélectronique selon la revendication 4,
sachant que la couche diélectrique (15) est disposée au moins partiellement entre la couche de renforcement métallique (14) et la traversée de contact p (7).

6. Composant semiconducteur optoélectronique selon une quelconque des revendications précédentes,
sachant que la succession de couches semiconductrices (2) est entourée au moins par zones par le support (10) dans la direction latérale.

7. Composant semiconducteur optoélectronique selon la revendication 6,
sachant que la couche de renforcement (14) est, vue dans la direction latérale, disposée par zones entre la succession de couches semiconductrices (14) et le support (10).

8. Composant semiconducteur optoélectronique selon une quelconque des revendications précédentes,
sachant que sur une surface de sortie du rayonnement (16) du composant semiconducteur optoélectronique (100) est disposée une couche du convertisseur (20).

9. Composant semiconducteur optoélectronique selon la revendication 8,
sachant que la couche du convertisseur (20) dépasse dans la direction latérale d'une longueur L d'au moins 5 µm au-dessus de la succession de couches semiconductrices (2).

10. Composant semiconducteur optoélectronique selon les revendications 8 ou 9,
sachant que la couche du convertisseur (20) présente un chanfrein (28).

11. Composant semiconducteur optoélectronique selon une quelconque des revendications 8 à 10,
sachant que des surfaces latérales de la couche du convertisseur (20) sont couvertes avec une couche absorbant la lumière ou réfléchissante (27).

12. Composant semiconducteur optoélectronique selon la revendication 11,
sachant que la couche absorbant la lumière (27) présente une épaisseur croissante vers la surface de la couche du convertisseur (20).

13. Composant semiconducteur optoélectronique selon une quelconque des revendications précédentes,
sachant que le support (10) présente une résine époxy ou une silicone.

14. Composant semiconducteur optoélectronique selon une quelconque des revendications précédentes,
sachant que la couche de contact n (8, 8A) présente au moins un contact de passage n (8A), qui est guidé à travers un ajour dans la zone de semiconducteur de type p (3) et que la couche active (4) est guidée dans la zone semiconductrice de type n (5).

15. Composant semiconducteur optoélectronique selon une quelconque des revendications précédentes,
sachant qu'au moins l'une des traversées de contact p (7) est espacée d'au moins l'un des contacts de passage n (8A) dans la direction latérale.

16. Composant semiconducteur optoélectronique selon une quelconque des revendications précédentes,
sachant que la couche de contact p (6) est couverte par zones d'une couche de blindage diélectrique anorganique (9).

17. Procédé en vue de la fabrication d'un composant semiconducteur optoélectronique (100) selon une quelconque des revendications précédentes,
sachant que la couche de renforcement (14) et la traversée de contact p (7) sont fabriquées par séparation galvanique.

18. Procédé selon la revendication 17 en se référant au moins à la revendication 4,
sachant que la couche diélectrique (15) est une couche d'oxyde de silicium et est fabriquée par CVD à partir du tétraéthylorthosilicate.
